# EUROPEAN PATENT APPLICATION

(11) **EP 3 166 134 A1**
(43) Date of publication of application: **10.05.2017**
(21) Application number: 16196133.9
(22) Date of filing: 27.10.2016
(51) Int. Cl.: H01L 21/768, H01L 21/285, H01L 23/48

(54) **CONDUCTIVE PLUG STRUCTURE AND FABRICATION METHOD THEREOF**

(30) Priority: 03.11.2015 CN 201510736229
(71) Applicant: Semiconductor Manufacturing International Corporation (Shanghai), Shanghai 201203 (CN); Semiconductor Manufacturing International Corporation (Beijing), Beijing 1000176 (CN)
(72) Inventor: ZHANG, Guanqun, Shanghai, 201203 (CN); HE, Peng, Shanghai, 201203 (CN); JIANG, Jianyong, Shanghai, 201203 (CN)
(74) Representative: Klunker IP Patentanwälte PartG mbB

(57) **Abstract**

The present invention provides a fabrication method for forming a conductive plug structure, including: providing a semiconductor substrate; forming a contact hole in the semiconductor substrate; forming an insulating layer on the semiconductor substrate and a bottom and sidewalls of the contact hole; and forming a metal conductive layer on the insulating layer to fill up the contact hole, the metal conductive layer including two or more stacking metal conductive unit layers (1, 2), each metal conductive unit layer having a metal nucleation layer (1a, 2a) and a metal bulk layer (1b, 2b) on the metal nucleation layer.

## Description

### CROSS-REFERENCES TO RELATED APPLICATIONS

This application claims the priority of Chinese Patent Application No. 201510736229.6, filed on November 3,2015.

### FIELD OF THE INVENTION

The present invention relates to the field of semiconductor technology, more particularly, relates to a conductive plug structure and a fabrication method for forming the conductive plug structure.

### BACKGROUND

As semiconductor technology advances, the feature size of semiconductor devices becomes smaller and smaller, and it has become more difficult to increase the number of semiconductor devices in two dimensional packaging structures. Three dimensional packaging has become an effective way to improve the integration level of semiconductor devices. Currently, the commonly used three dimensional packaging methods include die stacking based on gold wire bonding, package stacking, and through-silicon via (TSV) packaging. TSV is based on forming through holes in a silicon wafer, and the three dimensional packaging method based on TSV has some advantages such as high integration density, which enables the lengths of electric vias to be greatly shortened or decreased. In this way, signal delay issues in two dimensional packaged semiconductor devices can be effectively resolved. By using the TSV technology, modules with different functions, e.g., radio frequency (RF) modules, memory modules, logic modules, and microelectromechanical systems (MEMS), may be integrated together for packaging. Thus, three dimensional packaging method based on TSV has become an increasingly important semiconductor packaging method.

A conventional method to form a conductive plug structure based on the TSV technology often includes: providing a semiconductor substrate; etching the semiconductor substrate to form contact holes in the semiconductor substrate; depositing a conductive layer to fill up the contact holes and to cover the tungsten conductive layer the surface of the semiconductor substrate; and performing a chemical mechanical polishing process to remove the tungsten conductive layer deposited on the surface of the semiconductor substrate to form the conductive plug.

As the feature size of fabrication decreases, conductive plug structures made of copper are widely used. However, copper has a relatively high diffusion coefficient in dielectric materials and has poor electromigration resistance, which can cause the semiconductor device to have impaired or even failed performance. Tungsten has a much lower diffusion coefficient in dielectric materials, and is thus often used as the filling material for conductive plug structures.

However, the conductive plug structure formed by conventional packaging methods may still have undesired properties. The disclosed conductive plug structure and the fabrication method for forming the conductive plug structure are directed to solve one or more problems set forth above and other problems.

### BRIEF SUMMARY OF THE INVENTION

A first aspect of the present invention provides a fabrication method for forming a conductive plug structure, including: providing a semiconductor substrate; forming a contact hole in the semiconductor substrate; forming an insulating layer on the semiconductor substrate and a bottom and sidewalls of the contact hole; and forming a metal conductive layer on the insulating layer to fill up the contact hole, the metal conductive layer including two or more stacking metal conductive unit layers, each metal conductive unit layer having a metal nucleation layer and a metal bulk layer on the metal nucleation layer.

A second aspect of the present invention provides a conductive plug structure, including: a semiconductor substrate; one or more contact holes in the semiconductor substrate; an insulating layer covering a bottom and sidewalls of each contact hole; and a metal conductive layer on the insulating layer filling up the contact hole, the metal conductive layer including two or more stacking metal conductive unit layers, each metal conductive unit layer having a metal nucleation layer and a metal bulk layer on the metal nucleation layer.

The fabrication method may further comprise planarizing the metal conductive layer and the insulating layer to expose the semiconductor substrate.

A thickness of the metal nucleation layer may range from about 20 Å to about 400 Å, and a thickness of the metal bulk layer ranges from about 200 Å to about 1000 Å.

A metal grain size of the metal nucleation layer may range from about 0.01 µm to about 0.15 µm.

A metal grain size of the metal bulk layer may range from about 0.1 µm to about 0.3 µm.

In the fabrication method, chemical vapor deposition (CVD) processes may be performed to form the metal nucleation layer and/or the metal bulk layer of a metal conductive layer.

A reactant gas to form the metal nucleation layer may include SiH4 and WF6, a flow rate of the SiH4 being about 10 sccm to about 200 sccm, a flow rate of the WF6 being bout 10 sccm to about 100 sccm, a pressure of a reactor being about 4 Torr to about 60 Torr, a temperature of the CVD process being about 300°C to about 450°C.

A reactant gas to form the metal bulk layer may include H2 and WF6, a flow rate of the H2 being about 500 sccm to about 8000 sccm, a flow rate of the WF6 being bout 30 sccm to about 150 sccm, a pressure of a reactor being about 30 Torr to about 300 Torr, a temperature of the CVD process being about 300°C to about 450°C.

In the fabrication method, before the metal conductive layer is formed, an adhesion layer may be formed on the insulating layer for enhancing adhesion between the insulating layer and the metal conductive layer.

The adhesive layer may be formed by a physical vapor deposition (PCD) process, a thickness of the adhesive layer ranging from about 100 Å to about 500 Å.

In the fabrication method, before the metal conductive layer is formed, a barrier layer may be formed on the insulating layer for preventing metal atoms of the metal conductive layer from diffusing into the semiconductor substrate.

The barrier layer may be formed by one or more of an atom layer deposition (ALD) process and an or metal organic chemical vapor deposition (MOCVD) process, a thickness of the barrier layer ranging from about 50 Å to about 500 Å.

The semiconductor substrate may be made one or more of silicon, germanium, silicon germanium, and gallium arsenide.

The insulating layer may be made of an oxide material.

The metal conductive layer may be made of tungsten.

In the fabrication method, a chemical mechanical polishing may be used to planarize the metal conductive layer and the insulating layer.

A top dimension of a contact hole may be equal to or greater than about 0.065 ?m.

Other aspects or embodiments of the present invention can be understood by those skilled in the art in light of the description, the claims, and the drawings of the present invention.

### BRIEF DESCRIPTION OF THE DRAWINGS

The following drawings are merely examples for illustrative purposes according to various disclosed embodiments and are not intended to limit the scope of the present invention which is defined in the claims.
FIGS. 1-6 illustrate an exemplary conductive plug structure at different stages of an exemplary fabrication process consistent with various disclosed embodiments of the present invention;
FIGS. 7-9 illustrate another exemplary conductive plug structure at different stages of another exemplary fabrication process consistent with various disclosed embodiments of the present invention;
FIGS. 10-12 illustrate another exemplary conductive plug structure at different stages of another exemplary fabrication process consistent with various disclosed embodiments of the present invention;
FIG. 13 illustrates a scanning electron microscope (SEM) image showing an exemplary conductive plug structure consistent with various disclosed embodiments of the present invention;
FIG. 14 illustrates an SEM image showing a conventional conductive plug structure; and
FIG. 15 illustrates an exemplary fabrication process of a conductive plug structure consistent with various disclosed embodiments.

### DETAILED DESCRIPTION

Reference will now be made in detail to exemplary embodiments of the invention, which are illustrated in the accompanying drawings. Hereinafter, embodiments consistent with the invention will be described with reference to drawings. Wherever possible, the same reference numbers will be used throughout the drawings to refer to the same or like parts. It is apparent that the described embodiments are some but not all of the embodiments of the present invention.

Although tungsten has a lower diffusion coefficient in dielectric materials, conventional conductive plug structures made of tungsten may not desirably fill up the contact holes in the semiconductor devices.

To form a conductive plug structure using tungsten, a semiconductor substrate is often provided. The semiconductor substrate is further etched to form contact holes in the semiconductor substrate. A tungsten conductive layer is deposited to fill up the contact holes. The tungsten conductive layer also covers the surface of the semiconductor substrate. A chemical mechanical polishing process is often used to remove the tungsten conductive layer deposited on the surface of the semiconductor substrate. Thus, conductive plug structures are formed.

To improve the quality of the tungsten conductive layer, a single-layered tungsten nucleation layer is often formed in a contact hole, and a single-layered tungsten bulk layer is formed on the single-layered tungsten nucleation layer to fill up the contact hole. The single-layered tungsten nucleation layer and the single-layered tungsten bulk layer form the tungsten conductive layer. It is easier for the single-layered tungsten nucleation layer to attach to the bottom and the sidewalls of a contact hole and form seeds with small grain sizes. The single-layered tungsten bulk layer uses the single-layered tungsten nucleation layer as the growth base or the base for growth, until the single-layered tungsten bulk layer fills up the contact hole. The tungsten grain size of the single-layered tungsten bulk layer formed in this method is often undesirably large.

As the aspect ratio, i.e., the ratio of the width to the height, of a contact hole increases, if a tungsten conductive layer only includes a single-layered tungsten nucleation layer and a single-layered tungsten bulk layer on the single-layered tungsten nucleation layer, it may become more difficult to fill up the contact hole with the tungsten conductive layer. In other words, it may become more difficult for the tungsten conductive layer to fully contact the bottom of a contact hole. As a result, when the top opening of the contact hole is sealed or filled up with the tungsten conductive layer, gaps, i.e., space not filled by the tungsten conductive layer, may still exist in the contact hole. The gaps may be undesirably wide.

When the single-layered tungsten bulk layer is being formed, the tungsten grain size of tungsten that forms the single-layered tungsten bulk layer may be affected by, i.e., the tungsten grain size of the tungsten that form the single-layered tungsten nucleation layer and the reaction condition. The tungsten grain size of the single-layered tungsten bulk layer gradually increases until reaching a fixed value or fixed size. As the tungsten grain size of the single-layered tungsten bulk layer increases, the growth rate of the single-layered tungsten bulk layer increases, and the top opening of the contact hole is sealed within a shorter period of time. The gaps formed in the contact hole may be undesirably wide. As a result, the contact hole is poorly filled.

Further, the tungsten grain size of a tungsten bulk layer is closely related to the growth rate of the tungsten bulk layer. When the tungsten grain size is small, the tungsten bulk layer often has a lower growth rate. When the tungsten grain size is larger, the tungsten bulk layer often has a higher growth rate. When the tungsten bulk layer is using a tungsten nucleation layer as the growth base to grow until filling up a contact hole, the tungsten grain size of the tungsten bulk layer gradually increases. That is, the initial tungsten grain size of in the tungsten bulk layer is often smaller and the growth rate of the tungsten bulk layer is often slower. The tungsten grain size of the tungsten bulk layer gradually increases during growth and the growth rate of the tungsten bulk layer becomes higher. The tungsten grain size of a tungsten bulk layer is often in the range of about 0.1 µm to about 0.5 µm. The tungsten grain size of the tungsten bulk layer can be controlled or monitored to control the growth rate of the tungsten bulk layer. The widths of the gaps formed in a contact hole, with respect to the dimensions of the top opening of the contact hole, may be controlled.

One aspect of the present invention provides a fabrication method for forming a conductive plug structure. According to the fabrication method, a tungsten conductive layer is formed to fill up a contact hole. The tungsten conductive layer includes at least two stacking tungsten conductive unit layers. Each tungsten conductive unit layer includes a tungsten nucleation layer and a tungsten bulk layer formed on the tungsten nucleation layer. By forming the disclosed conductive plug structure, the gaps formed in the contact hole may have smaller widths with respect to the dimensions of the top opening of the contact hole. The contact hole can thus be better filled with the disclosed tungsten contact layer.

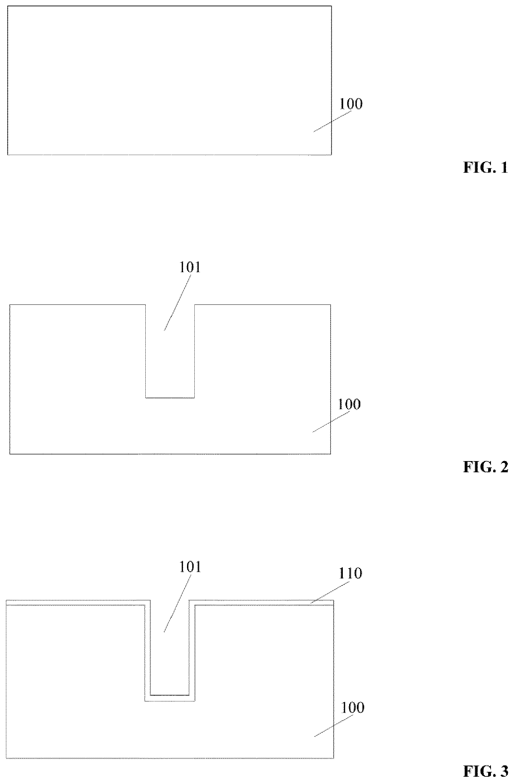

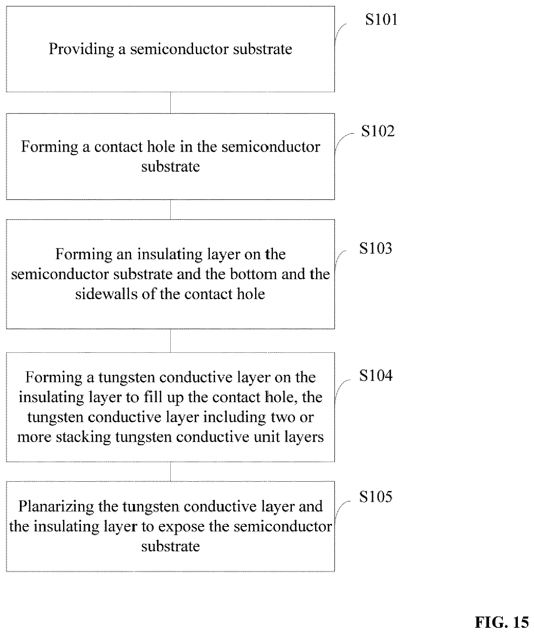

FIG. 15 illustrates an exemplary fabrication process of a conductive plug structure and FIGS. 1-6 illustrate a conductive plug structure corresponding to various stages of an exemplary fabrication process. The fabrication of a conductive plug structure is described in connection with FIGS. 1-6.

As shown in FIG. 15, at the beginning of the fabrication process, a semiconductor substrate is provided (S101). FIG. 1 illustrates a corresponding conductive plug structure.

As shown in FIG. 1, a semiconductor substrate 100 may be provided. The semiconductor substrate 100 may be made of monocrystalline silicon, polysilicon, and/or amorphous silicon. The semiconductor substrate 100 may also be made of other suitable semiconductor materials such as silicon, germanium, silicon germanium, and/or gallium arsenide. In one embodiment, the semiconductor substrate 100 may be made of silicon.

Returning to FIG. 15, after the semiconductor substrate is provided, a contact hole is formed in the semiconductor substrate (S102). FIG. 2 illustrates a corresponding conductive plug structure.

As shown in FIG. 2, a contact hole 101 may be formed in the semiconductor substrate 100. The contact hole 101 may provide space for the subsequently-formed tungsten conductive layer.

Specifically, a mask layer (not shown) for defining the location of the contact hole 101 may be formed on the semiconductor substrate 100. An etch pattern may be formed and the mask layer may be used as the etch mask to etch the semiconductor substrate 100 and form a contact hole 101.

One or more contact holes 101 may be formed. For illustrative purposes, one contact hole 101 may be depicted as an example to describe the invention. In practice, the number of contact holes 101 formed may be determined or adjusted according to different applications and/or designs. For example, in practice, the semiconductor substrate 100 may include a central region and an edge region. In some embodiments, contact holes 101 may be formed both in the central region and the edge region.

A deep reactive ion etching process may be used to form the contact hole 101. The deep reactive ion etching process may be a Bosch deep reactive ion etching (Bosch DRIE) process and/or a cryogenic deep reactive ion etching (Cryogenic DRIE).

In one embodiment, a Bosch DRIE process may be used to form the contact hole 101. To form the contact hole 101, the mask layer may be used as the etch mask. An etchant gas and a protective gas may be introduced to the reactor alternately, to alternately etch the semiconductor substrate 100 and protect the sidewalls formed after an etching step, until the contact hole 101 with desired dimensions is formed.

As the feature size of semiconductor devices continues to decrease, the aspect ratio of a contact hole 101 used for forming a conductive plug structure continues to increase. In one embodiment, the aspect ratio of the contact hole 101 may range from about 5 to about 10.

Returning to FIG. 15, after the contact hole is formed, an insulating layer is formed on the semiconductor substrate, and the bottom and the sidewalls of the contact hole (S103). FIG. 3 illustrates a corresponding conductive plug structure.

As shown in FIG. 3, an insulating layer 110 may be formed on the semiconductor substrate 100, and the bottom and the sidewalls of the contact hole 101. The insulating layer 110 may be configured to provide electrical insulation between the semiconductor substrate 100 and the subsequently-formed tungsten conductive layer. The insulating layer 110 maybe made of an oxide material. In one embodiment, the insulating layer 110 may be made of silicon dioxide.

The method or process to form the insulating layer 110 may include atmospheric pressure chemical vapor deposition (APCVD), plasma enhanced chemical vapor deposition (PECVD), low pressure chemical vapor deposition (LPCVD), and/or atom layer deposition (ALD).

In some embodiments, an adhesive layer (not shown) may be formed on the insulating layer 110. The adhesive layer may be configured to increase the adhesion between the insulating layer 110 and the subsequently-formed tungsten conductive layer. In some embodiments, the adhesive layer may be made of titanium. The adhesive layer may be formed by a suitable deposition process such as physical vapor deposition. The thickness of the adhesive layer may range from about 100 Å to about 500 Å.

In some embodiments, a barrier layer (not shown) may be formed on the adhesive layer. The barrier layer may be configured to prevent the tungsten atoms in the subsequently-formed tungsten conductive layer from diffusing into the semiconductor substrate 100. The barrier layer may also be configured to prevent the reactant gas for forming the tungsten conductive layer, e.g., WF₆, from reacting with the adhesive layer. The barrier layer may be made of a suitable material such as titanium nitride, and be formed by a suitable deposition process. For example, the deposition process may be an ALD process and/or a metal organic chemical vapor deposition (MOCVD) process. The thickness of the barrier layer may be about 50 Å to about 500 Å.

If no adhesive layer is formed on the insulating layer 110, the barrier layer may be formed directly on the insulating layer 110.

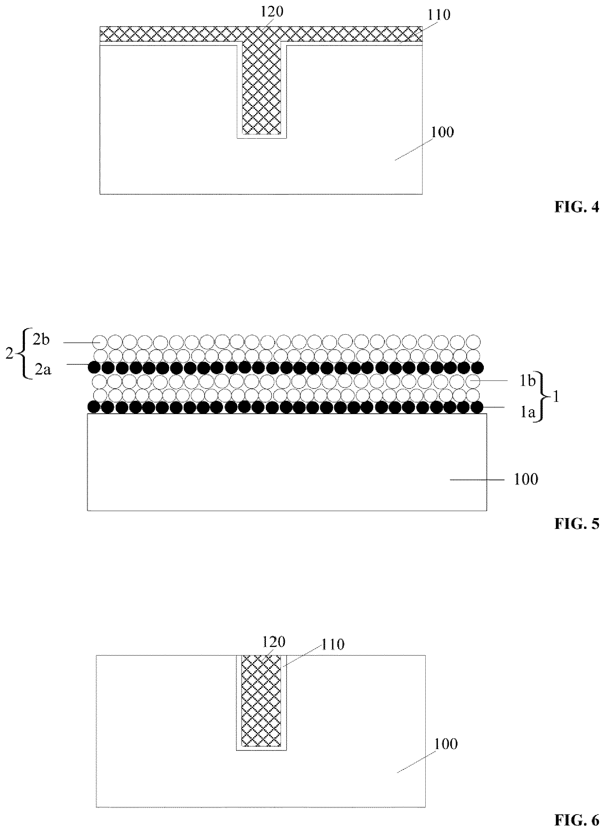

Returning to FIG. 15, after the insulating layer is formed, a tungsten conductive layer is formed on the insulating layer to fill up the contact hole, the tungsten conductive layer including two or more stacking tungsten conductive unit layers (S104). FIG. 4 illustrates a corresponding conductive plug structure.

As shown in FIG. 4, a tungsten conductive layer 120 may be formed on the insulating layer 110 to fill up the contact hole 101, the tungsten conductive layer 120 including two or more stacking tungsten conductive unit layers. In one embodiment, two stacking tungsten conductive unit layers may be formed.

FIG. 5 illustrates an exemplary tungsten conductive layer 120 with two stacking tungsten conductive unit layers. That is, the tungsten conductive layer 120 may include a first tungsten conductive unit layer 1 and a second tungsten conductive unit layer 2. The second tungsten conductive layer 2 may be formed on the first tungsten conductive unit layer 1.

The first tungsten conductive unit layer 1 may include a first tungsten nucleation layer 1a and a first tungsten bulk layer 1b, where the first tungsten bulk layer 1b may be formed on the first tungsten nucleation layer 1a. The second tungsten conductive unit layer 2 may include a second tungsten nucleation layer 2a and a second tungsten bulk layer 2b, where the second tungsten bulk layer 2b may be formed on the second tungsten nucleation layer 2a. The first tungsten bulk layer 1b may be formed using the first tungsten nucleation layer 1a as the growth base. The second tungsten bulk layer 2b may be formed using the second tungsten nucleation layer 2a as the growth base.

It should be noted that, FIG. 5 only illustrates the tungsten nucleation layers and the tungsten bulk layers stacking along a direction parallel to the <100> orientation of the semiconductor substrate 100. The tungsten nucleation layers and the tungsten bulk layers stacking along a direction perpendicular to the <100> orientation of the semiconductor substrate 100 may be referred to the description of the tungsten conductive unit layers stacking along a direction parallel to the <100> orientation of the semiconductor substrate 100 and is not repeated herein.

In one embodiment, the tungsten conductive layer 120 may include two stacking tungsten conductive unit layers. The tungsten conductive layer 120 maybe configured to fill up a contact hole 101 with an aspect ratio of about 5 to about 10 and a top opening with dimensions of about 0.065 µm to about 0.28 µm.

In one embodiment, a CVD process may be performed to form the first tungsten nucleation layer 1 a, the first tungsten bulk layer 1b, the second tungsten nucleation layer 2a, and the second tungsten bulk layer 2b. In other various embodiments of the present invention, other suitable deposition methods, e.g., physical vapor deposition (PVD), may also be used to form the first tungsten nucleation layer 1a, the first tungsten bulk layer 1b, the second tungsten nucleation layer 2a, and the second tungsten bulk layer 2b. Compared to a tungsten conductive layer 120 formed by a PVD process, a tungsten conductive layer 120 formed by a CVD process may better fill up the contact hole 101.

In one embodiment, to form the tungsten conductive layer 120, SiH₄ and WF₆ may be introduced into the reactor. SiH₄ and WF₆ may react to form the first tungsten nucleation layer 1a. After the first tungsten nucleation layer 1a is formed, H₂ and WF₆ may be introduced into the reactor. H₂ and WF₆ may react to form the first tungsten bulk layer 1b. Further, SiH₄ and WF₆ may be introduced into the reactor. SiH₄ and WF₆ may reactor to form the second tungsten nucleation layer 2a. After the second tungsten nucleation layer 2a is formed, H₂ and WF₆ may be introduced into the reactor. H₂ and WF₆ may react to form the second tungsten bulk layer 2b.

In one embodiment, the CVD process used to form the first tungsten nucleation layer 1a and the second tungsten nucleation layer 2a may include the following parameters. The reactant gas to form the first tungsten nucleation layer 1a and the second tungsten nucleation layer 2a may include SiH₄ and WF₆. The flow rate of the SiH₄ may range from about 10 sccm to about 200 sccm. The flow rate of WF₆ may range from about 10 sccm to about 100 sccm. The pressure in the reactor may range from about 4 Torr to about 60 Torr. The reaction temperature may range from about 300 °C to about 450 °C. The reaction between SiH₄ and WF₆ is 3SiH₄+2WF₆->2W+3SiF₄+6H₂.

In one embodiment, the CVD process to form the first tungsten bulk layer 1b and the second tungsten bulk layer 2b may include the following parameters. The reactant gas to form the first tungsten bulk layer 1b and the second tungsten bulk layer 2b may include H₂ and WF₆. The flow rate of H₂ may range from about 500 sccm to about 8000 sccm. The flow rate of WF₆ may range from about 30 sccm to about 150 sccm. The pressure in the reactor may range from about 30 Torr to about 300 Torr. The reaction temperature may range from about 300 °C to about 450 °C. The reaction between H₂ and WF₆ is 3H₂+WF₆-> W+6HF.

In one embodiment, the tungsten grain sizes of the first tungsten nucleation layer 1a and the second tungsten nucleation layer 2a may range from about 0.01 µm to about 0.15 µm. The tungsten grain sizes of the first tungsten bulk layer 1b and the second tungsten bulk layer 2b may range from about 0.1 µm to about 0.3 µm.

The average tungsten grain size of a tungsten nucleation layer may be smaller than the average tungsten grain size of a tungsten bulk layer so that the resistivity of a tungsten nucleation layer is higher than the resistivity of a tungsten bulk layer. In some embodiments, the average tungsten grain size of each tungsten nucleation layer may be smaller than the average tungsten grain size of each tungsten bulk layer so that the resistivity of each tungsten nucleation layer is higher than the resistivity of each tungsten bulk layer.

The thickness of each tungsten nucleation layer and the thickness of each tungsten bulk layer may be determined to be in a suitable range. In one embodiment, the thickness of a tungsten nucleation layer may range from about 20 Å to about 400 Å, and the thickness of a tungsten bulk layer may range from about 200 Å to about 1000 Å. The reason for choosing such thickness ranges may include the following reasons.

For example, if the thickness of a tungsten nucleation layer is less than about 20 Å, the tungsten nucleation layer may not be consistently distributed and the coverage of the tungsten nucleation layer may be reduced. If the thickness of a tungsten nucleation layer is greater than about 400 Å, the resistivity of the tungsten conductive layer may be too high. If the thickness of a tungsten bulk layer is less than about 200 Å, the resistivity of the tungsten conductivity layer may be too high. If the thickness of a tungsten bulk layer is greater than about 1000 Å, the tungsten grain size of the tungsten bulk layer may be undesirably large. The growth rate of the tungsten bulk layer may increase. Accordingly, the contact hole may be poorly filled by the tungsten conductive layer.

Returning to FIG. 15, after the tungsten conductive layer is formed, the tungsten conductive layer and the insulating layer are planarized to expose the semiconductor substrate (S105). FIG. 6 illustrates a corresponding conductive plug structure.

As shown in FIG. 6, the tungsten conductive layer 120 and the insulating layer 110 may be planarized to expose the semiconductor substrate 100. After the tungsten conductive layer 120 and the insulating layer 110 are planarized, a conductive plug structure may be formed.

In one embodiment, a chemical mechanical polishing process may be performed to planarize the tungsten conductive layer 120 and the insulating layer 110. In certain other embodiments, other suitable planarization processes may also be used to planarize the tungsten conductive layer 120 and the insulating layer 110.

The disclosed conductive plug structure, as shown in FIG. 6, may include a semiconductor substrate 100 and a contact hole 101 (referring to FIG. 2) formed in the semiconductor substrate 100. The conductive plug structure may also include an insulating layer 110 formed on the bottom and the sidewalls of the contact hole 101. The conductive plug structure may further include a tungsten conductive layer 120 formed on the insulating layer 110 and filling up the contact hole 101. The tungsten conductive layer 120 may include a first tungsten conductive unit layer 1 (referring to FIG. 5) and a second tungsten conductive unit layer 2 disposed on the first tungsten conductive unit layer 1.

The first tungsten conductive unit layer 1 may include a first tungsten nucleation layer 1a (referring to FIG. 5) and a first tungsten bulk layer 1b disposed on the first tungsten nucleation layer 1a (referring to FIG. 5). The second tungsten conductive unit layer 2 may include a second tungsten nucleation layer 2a (referring to FIG. 5) and a second tungsten bulk layer 2b disposed on the second tungsten nucleation layer 2a (referring to FIG. 5). The first tungsten conductive unit layer 1 and the second tungsten conductive unit layer 2 may form two stacking tungsten conductive unit layers.

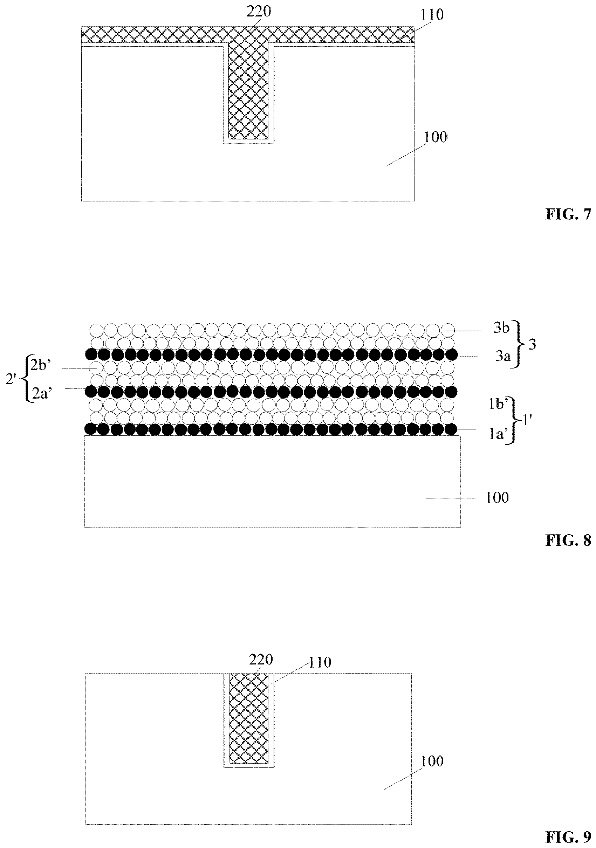

FIGS. 7-9 illustrate the fabrication process of another exemplary conductive plug structure. Different from the embodiment shown in FIGS. 1-6, the tungsten conductive layer depicted in FIGS. 7-9 may include three stacking tungsten conductive unit layers.

FIG. 7 illustrates the tungsten conductive layer formed based on the structure shown in FIG. 3. For example, a tungsten conductive layer 220 may be formed on the insulating layer 110 to fill up the contact hole 101. The tungsten conductive layer 220 may include three stacking tungsten conductive unit layers.

As shown in FIG. 8, the tungsten conductive layer 220 may include three stacking tungsten conductive unit layers. That is, the tungsten conductive layer 220 may include a first tungsten conductive unit layer 1', a second tungsten conductive unit layer 2' disposed on the first tungsten conductive unit layer 1', and a third tungsten conductive unit layer 3 disposed on the second tungsten conductive unit layer 2'.

The first tungsten conductive unit layer 1' may include a first tungsten nucleation layer 1a' and a first tungsten bulk layer 1b' disposed on the first tungsten nucleation layer 1a'. The second tungsten conductive unit layer 2' may include a second tungsten nucleation layer 2a' and a second tungsten bulk layer 2b' disposed on the second tungsten nucleation layer 2a'. The third tungsten conductive unit layer 3 may include a third tungsten nucleation layer 3a and a third tungsten bulk layer 3b disposed on the third tungsten nucleation layer 3a.

The first tungsten bulk layer 1b' may be formed by using the first tungsten nucleation layer 1a' as the growth base. The second tungsten bulk layer 2b' may be formed by using the second tungsten nucleation layer 2a' as the growth base. The third tungsten bulk layer 3b may be formed by using the third tungsten nucleation layer 3a as the growth base.

It should be noted that, FIG. 8 only illustrates the tungsten nucleation layers and the tungsten bulk layers stacking along a direction parallel to the <100> orientation of the semiconductor substrate 100. The tungsten nucleation layers and the tungsten bulk layers stacking along a direction perpendicular to the <100> orientation of the semiconductor substrate 100 may be referred to the description of the tungsten nucleation layers and the tungsten bulk layers stacking along a direction parallel to the <100> orientation of the semiconductor substrate 100 and is not repeated herein.

In one embodiment, the tungsten conductive layer 220 may include three stacking tungsten conductive unit layers. In this case, the tungsten conductive layer 220 may be configured to fill up a contact hole 101 with an aspect ratio of about 5 to about 10 and a top opening with dimensions of about 0.065 µm to about 0.42 µm.

In one embodiment, a CVD process may be performed to form the first tungsten nucleation layer 1a', the first tungsten bulk layer 1b', the second tungsten nucleation layer 2a', the second tungsten bulk layer 2b', the third tungsten nucleation layer 3 a, and the third tungsten bulk layer 3b.

In one embodiment, to form the tungsten conductive layer 220, SiH₄ and WF₆ may be introduced into the reactor. SiH₄ and WF₆ may react to form the first tungsten nucleation layer 1a'. After the first tungsten nucleation layer 1a' is formed, H₂ and WF₆ may be introduced into the reactor. H₂ and WF₆ may react to form the first tungsten bulk layer 1b'. Further, SiH₄ and WF₆ may be introduced into the reactor. SiH₄ and WF₆ may reactor to form the second tungsten nucleation layer 2a'. After the second tungsten nucleation layer 2a' is formed, H₂ and WF₆ may be introduced into the reactor. H₂ and WF₆ may react to form the second tungsten bulk layer 2b'. After the second tungsten bulk layer 2b' is formed, SiH₄ and WF₆ may be introduced into the reactor. SiH₄ and WF₆ may react to form the third tungsten nucleation layer 3a. After the third tungsten nucleation layer 3a is formed, H₂ and WF₆ may be introduced into the reactor. H₂ and WF₆ may react to form the third tungsten bulk layer 3b.

In one embodiment, the CVD process to form the first tungsten nucleation layer 1a', the second tungsten nucleation layer 2a', and the third tungsten nucleation layer 3a may include the following parameters. The reactant gas may include SiH₄ and WF₆. The flow rate of the SiH₄ may range from about 10 sccm to about 200 sccm. The flow rate of WF₆ may range from about 10 sccm to about 100 sccm. The pressure in the reactor may range from about 4 Torr to about 60 Torr. The reaction temperature may range from about 300 °C to about 450 °C.

In one embodiment, the CVD process to form the second tungsten bulk layer 1b', the second tungsten bulk layer 2b', and the third tungsten bulk layer 3b may include the following parameters. The reactant gas may include H₂ and WF₆. The flow rate of the H₂ may range from about 500 sccm to about 8000 sccm. The flow rate of the WF₆ may range from about 30 sccm to about 150 sccm. The pressure in the reactor may range from about 30 Torr to about 300 Torr. The reaction temperature may range from about 300 °C to about 450 °C.

In one embodiment, the tungsten grain sizes of the first tungsten nucleation layer 1a', the second tungsten nucleation layer 2a', and the third tungsten nucleation layer 3a may range from about 0.01 µm to about 0.15 µm. The tungsten gran sizes of the first tungsten bulk layer 1b', the second tungsten bulk layer 2b', and the third tungsten bulk layer 3b may range from about 0.1 µm to about 0.3 µm.

The thickness of the first tungsten nucleation layer 1a', the second tungsten nucleation layer 2a', and the third tungsten nucleation layer 3a may each range from about 20 Å to about 400 Å. The thickness of the first tungsten bulk layer 1b', the second tungsten bulk layer 2b', and the third tungsten bulk layer 3b may each range from about 200 Å to about 1000 Å.

As shown in FIG. 9, the tungsten conductive layer 220 and the insulating layer 110 may be planarized to expose the semiconductor substrate 100. After the tungsten conductive layer 220 and the insulating layer 110 are planarized, a conductive plug structure may be formed.

The disclosed conductive plug structure, as shown in FIG. 9, may include a semiconductor substrate 100 and a contact hole 101 (referring to FIG. 2) formed in the semiconductor substrate 100. The conductive plug structure may also include an insulating layer 110 formed on the bottom and the sidewalls of the contact hole 101. The conductive plug structure may further include a tungsten conductive layer 220 formed on the insulating layer 110 and filling up the contact hole 101. The tungsten conductive layer 220 may include a first tungsten conductive unit layer 1' (referring to FIG. 8), a second tungsten conductive unit layer 2' disposed on the first tungsten conductive unit layer 1', and a third tungsten conductive unit layer 3 disposed on the second tungsten conductive unit layer 2'. The first tungsten conductive unit layer 1' may include a first tungsten nucleation layer 1a' (referring to FIG. 8) and a first tungsten bulk layer 1b' disposed on the first tungsten nucleation layer 1a' (referring to FIG. 8). The second tungsten conductive unit layer 2' may include a second tungsten nucleation layer 2a' (referring to FIG. 8) and a second tungsten bulk layer 2b' disposed on the second tungsten nucleation layer 2a' (referring to FIG. 8). The third tungsten conductive unit layer 3 may include a third tungsten nucleation layer 3a (referring to FIG. 8) and a third tungsten bulk layer 3b disposed on the second tungsten nucleation layer 3a (referring to FIG. 8).

The first tungsten conductive unit layer 1', the second tungsten conductive unit layer 2', and the third tungsten conductive unit layer 3 may form three stacking tungsten conductive unit layers.

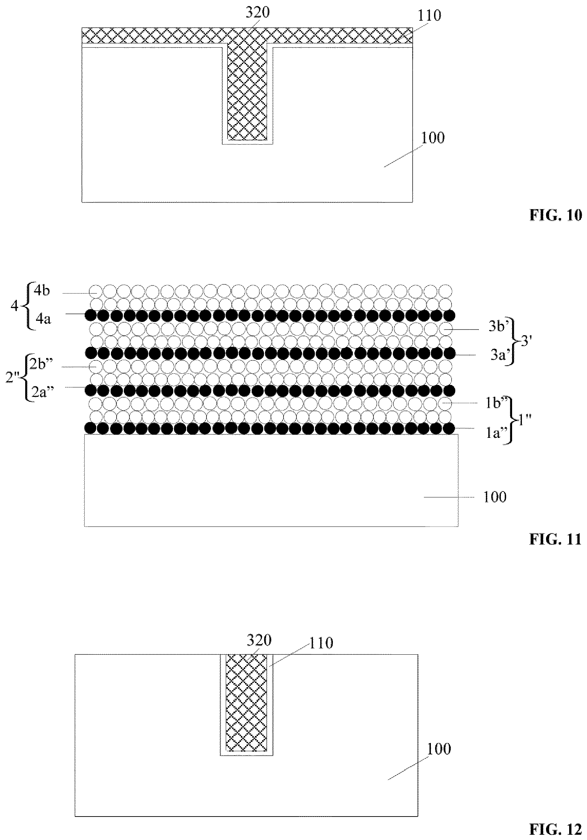

FIGS. 10-12 illustrate the fabrication process of another exemplary conductive plug structure. Different from the structures shown in FIGS. 1-6 and FIGS. 7-9, the tungsten conductive layer depicted in FIGS. 10-12 may include four stacking tungsten conductive unit layers.

FIG. 10 illustrates the tungsten conductive layer formed based on the structure shown in FIG. 3. For example, a tungsten conductive layer 320 may be formed on the insulating layer 110 to fill up the contact hole 101. The tungsten conductive layer 220 may include four stacking tungsten conductive unit layers.

As shown in FIG. 11, the tungsten conductive layer 320 may include four stacking tungsten conductive unit layers. That is, the tungsten conductive layer 320 may include a first tungsten conductive unit layer 1 ", a second tungsten conductive unit layer 2" disposed on the first tungsten conductive unit layer 1", a third tungsten conductive unit layer 3' disposed on the second tungsten conductive unit layer 2", and a fourth tungsten conductive unit layer 4 disposed on the third tungsten conductive unit layer 3'.

The first tungsten conductive unit layer 1" may include a first tungsten nucleation layer 1a" and a first tungsten bulk layer 1b" disposed on the first tungsten nucleation layer 1a". The second tungsten conductive unit layer 2" may include a second tungsten nucleation layer 2a" and a second tungsten bulk layer 2b" disposed on the second tungsten nucleation layer 2a". The third tungsten conductive unit layer 3' may include a third tungsten nucleation layer 3a' and a third tungsten bulk layer 3b' disposed on the third tungsten nucleation layer 3a'. The fourth tungsten conductive unit layer 4 may include a fourth tungsten nucleation layer 4a and a fourth tungsten bulk layer 4b disposed on the third tungsten nucleation layer 4a.

The first tungsten bulk layer 1b" may be formed by using the first tungsten nucleation layer 1a" as the growth base. The second tungsten bulk layer 2b" may be formed by using the second tungsten nucleation layer 2a" as the growth base. The third tungsten bulk layer 3b' may be formed by using the third tungsten nucleation layer 3a' as the growth base. The fourth tungsten bulk layer 4b may be formed by using the fourth tungsten nucleation layer 4a as the growth base.

It should be noted that, FIG. 11 only illustrates the tungsten nucleation layers and the tungsten bulk layers stacking along a direction parallel to the <100> orientation of the semiconductor substrate 100. The tungsten nucleation layers and the tungsten bulk layers stacking along a direction perpendicular to the <100> orientation of the semiconductor substrate 100 may be referred to the description of the tungsten nucleation layers and the tungsten bulk layers stacking along a direction parallel to the <100> orientation of the semiconductor substrate 100 and is not repeated herein.

In one embodiment, the tungsten conductive layer 320 may include fourth stacking tungsten conductive unit layers. In this case, the tungsten conductive layer 320 may be configured to fill up a contact hole 101 with an aspect ratio of about 5 to about 10 and a top dimension of about 0.09 µm to about 0.56 µm.

In one embodiment, a CVD process may be performed to form the first tungsten nucleation layer 1a", the first tungsten bulk layer 1b", the second tungsten nucleation layer 2a", the second tungsten bulk layer 2b", the third tungsten nucleation layer 3a', the third tungsten bulk layer 3b', the fourth tungsten nucleation layer 4a, and the fourth tungsten bulk 4b.

In one embodiment, to form the tungsten conductive layer 320, SiH₄ and WF₆ may be introduced into the reactor. SiH₄ and WF₆ may react to form the first tungsten nucleation layer 1a". After the first tungsten nucleation layer 1a" is formed, H₂ and WF₆ may be introduced into the reactor. H₂ and WF₆ may react to form the first tungsten bulk layer 1b". Further, SiH₄ and WF₆ may be introduced into the reactor. SiH₄ and WF₆ may reactor to form the second tungsten nucleation layer 2a". After the second tungsten nucleation layer 2a" is formed, H₂ and WF₆ may be introduced into the reactor. H₂ and WF₆ may react to form the second tungsten bulk layer 2b".

After the second tungsten bulk layer 2b" is formed, SiH₄ and WF₆ may be introduced into the reactor. SiH₄ and WF₆ may react to form the third tungsten nucleation layer 3a'. After the third tungsten nucleation layer 3a' is formed, H₂ and WF₆ may be introduced into the reactor. H₂ and WF₆ may react to form the third tungsten bulk layer 3b'. After the third tungsten bulk layer 3b' is formed, SiH₄ and WF₆ may be introduced into the reactor. SiH₄ and WF₆ may react to form the fourth tungsten nucleation layer 4a. After the fourth tungsten nucleation layer 4a is formed, H₂ and WF₆ may be introduced into the reactor. H₂ and WF₆ may react to form the fourth tungsten bulk layer 4b.

In one embodiment, the CVD process to form the first tungsten nucleation layer 1a", the second tungsten nucleation layer 2a", the third tungsten nucleation layer 3a', and the fourth tungsten nucleation layer 4a may include the following parameters. The reactant gas may include SiH₄ and WF₆. The flow rate of the SiH₄ may range from about 10 sccm to about 200 sccm. The flow rate of WF₆ may range from about 10 sccm to about 100 sccm. The pressure in the reactor may range from about 4 Torr to about 60 Torr. The reaction temperature may range from about 300 °C to about 450 °C.

In one embodiment, the CVD process to form the second tungsten bulk layer 1b", the second tungsten bulk layer 2b", the third tungsten bulk layer 3b', and the fourth tungsten bulk layer 4b may include the following parameters. The reactant gas may include H₂ and WF₆. The flow rate of the H₂ may range from about 500 sccm to about 8000 sccm. The flow rate of WF₆ may range from about 30 sccm to about 150 sccm. The pressure in the reactor may range from about 30 Torr to about 300 Torr. The reaction temperature may range from about 300 °C to about 450 °C.

In one embodiment, the tungsten gran sizes of the first tungsten nucleation layer 1a", the second tungsten nucleation layer 2a", the third tungsten nucleation layer 3a', and the fourth tungsten nucleation 4a may range from about 0.01 µm to about 0.15 µm. The tungsten gran sizes of the first tungsten bulk layer 1b", the second tungsten bulk layer 2b", the third tungsten bulk layer 3b', and the fourth tungsten bulk layer 4b may range from about 0.1 µm to about 0.3 µm.

The thickness of the first tungsten nucleation layer 1a", the second tungsten nucleation layer 2a", the third tungsten nucleation layer 3a', and the fourth tungsten nucleation layer 4a may each range from about 20 Å to about 400 Å. The thickness of the first tungsten bulk layer 1b", the second tungsten bulk layer 2b", the third tungsten bulk layer 3b', and the fourth tungsten bulk layer 4b may each range from about 200 Å to about 1000 Å.

As shown in FIG. 12, the tungsten conductive layer 320 and the insulating layer 110 may be planarized to expose the semiconductor substrate 100. After the tungsten conductive layer 320 and the insulating layer 110 are planarized, a conductive plug structure may be formed.

The disclosed conductive plug structure, as shown in FIG. 12, may include a semiconductor substrate 100 and a contact hole 101 (referring to FIG. 2) formed in the semiconductor substrate 100. The conductive plug structure may also include an insulating layer 110 formed on the bottom and the sidewalls of the contact hole 101. The conductive plug structure may further include a tungsten conductive layer 320 formed on the insulating layer 110 and filling up the contact hole 101. The tungsten conductive layer 320 may include a first tungsten conductive unit layer 1" (referring to FIG. 11), a second tungsten conductive unit layer 2" disposed on the first tungsten conductive unit layer 1", a third tungsten conductive unit layer 3' disposed on the second tungsten conductive unit layer 2", and a fourth tungsten conductive unit layer 4 disposed on the third tungsten conductive unit layer 3'.

The first tungsten conductive unit layer 1" may include a first tungsten nucleation layer 1a" (referring to FIG. 11) and a first tungsten bulk layer 1b" disposed on the first tungsten nucleation layer 1a" (referring to FIG. 11). The second tungsten conductive unit layer 2" may include a second tungsten nucleation layer 2a" (referring to FIG. 11) and a second tungsten bulk layer 2b" disposed on the second tungsten nucleation layer 2a" (referring to FIG. 11). The third tungsten conductive unit layer 3' may include a third tungsten nucleation layer 3a' (referring to FIG. 11) and a third tungsten bulk layer 3b' disposed on the second tungsten nucleation layer 3a (referring to FIG. 11). The fourth tungsten conductive unit layer 4 may include a fourth tungsten nucleation layer 4a (referring to FIG. 11) and a fourth tungsten bulk layer 4a disposed on the second tungsten nucleation layer 4a (referring to FIG. 11).

The first tungsten conductive unit layer 1 ", the second tungsten conductive unit layer 2", the third tungsten conductive unit layer 3', and the fourth tungsten conductive unit layer 4 may form four stacking tungsten conductive unit layers.

It should be noted that, the number of stacking tungsten conductive unit layers is only exemplary in the present invention. Based on the aspect ratio and the dimensions of the top opening of a contact hole, a suitable number of stacking tungsten conductive unit layers may be formed in the tungsten conductive layer. For example, five stacking tungsten conductive unit layers, six stacking tungsten conductive unit layers, or even more stacking tungsten conductive unit layers, may be formed until the contact hole is filled up. A tungsten conductive unit layer may include a tungsten nucleation layer and a tungsten bulk layer on the tungsten nucleation layer.

In practice, as the aspect ratio of a contact hole increases, the thickness of a tungsten bulk layer may be reduced to increase the number of tungsten conductive unit layers, to better fill up the contact hole. When the aspect ratio of a contact hole, the thickness of a tungsten nucleation layer, and the thickness of a tungsten bulk layer are kept unchanged, as the dimensions of the top opening of the contact hole increases, the number of tungsten conductive unit layers may need to be increased to fill up the contact hole.

In practice, the technical solution provided by the present invention may be suitable when the dimensions of the top opening of a contact hole are greater than about 0.065 µm. The technical solution provided by the present invention may be suitable for filling up a contact hole with an aspect ratio in the range of about 5 to about 10 and having a top opening with dimensions equal to or greater than about 0.065 µm. The technical solution may also be suitable for filling up a contact hole with an aspect ratio in the range of about 1 to about 5 and having a top opening with dimensions equal to or greater than about 0.065 µm.

Accordingly, because tungsten nucleation layers and tungsten bulk layers are formed alternately to fill up a contact hole, the tungsten nucleation layer in each tungsten conductive unit layer may have an enhanced confinement on the tungsten grain size of the corresponding tungsten bulk layer. That is, the tungsten grains of a tungsten bulk layer may be formed at the initial stage during the growth. The growth rate of the tungsten bulk layer may be kept desirably low. Each tungsten bulk layer may be formed using the tungsten nucleation layer in the same tungsten conductive unit layer as the growth base. Also, before the tungsten grain size of the tungsten bulk layer of a tungsten conductive unit layer increases to the fixed size, gas for forming the tungsten nucleation layer in the subsequent tungsten conductive unit layer may be introduced into the reactor. Tungsten bulk layer in the same subsequent tungsten conductive unit layer may further be formed. The process described above may be repeated until the contact hole is filled up. Compared to a conventional tungsten conductive layer with only a single-layered tungsten nucleation layer and a single-layered tungsten bulk layer on the singled tungsten nucleation layer, the tungsten grain size of the tungsten formed in the disclosed tungsten bulk layer may be kept within a smaller range, e.g., between about 0.1 µm to about 0.3 µm. Because the tungsten nucleation layers may have smaller grain sizes, the tungsten bulk layers may have slow growth rates. The difference between the growth/deposition rate of the tungsten bulk layer at the top opening of the contact hole and the growth rate of the tungsten bulk layer at the bottom of the contact hole may be reduced. It may take longer time to seal the contact hole with the disclosed tungsten conductive layer. The widths of the gaps formed in the contact hole may be reduced with respect to the dimensions of the top opening of the contact hole.

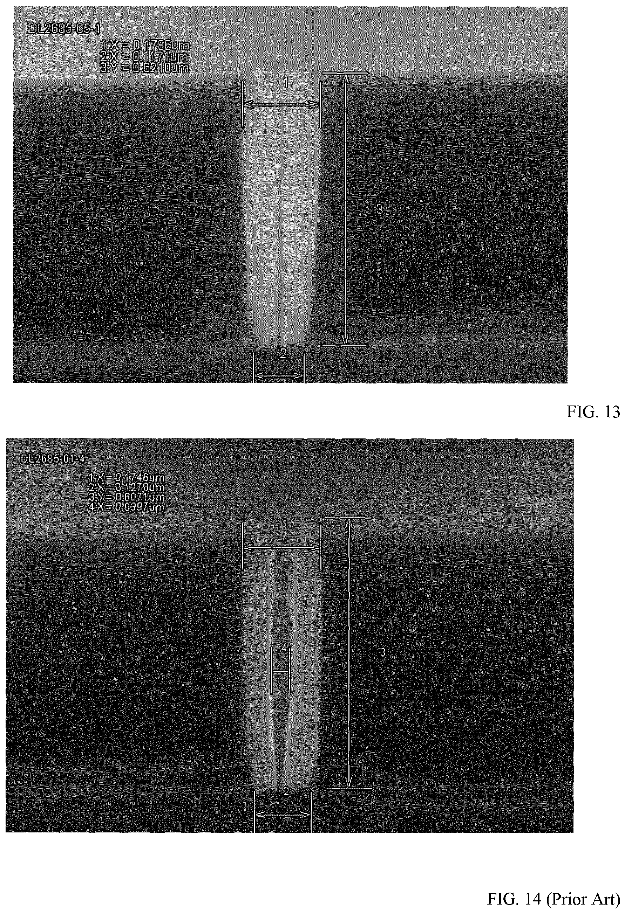

FIGS. 13 and 14 are each an SEM image of a gap formed in a contact hole. As shown in FIG. 13, the width of a gap, formed by the disclosed fabrication method, may have a reduced width with respect to the dimensions of the top opening of the contact hole. FIG. 14 illustrates the width of a gap, formed by the conventional fabrication method, having a larger width with respect to the dimensions of the top opening of the contact hole. By comparing FIG. 13 to FIG. 14, it is shown that by forming a tungsten conductive layer with a plurality of stacking tungsten conductive unit layers, each tungsten conductive unit layer including a tungsten nucleation layer and a tungsten bulk layer on the tungsten nucleation layer, defects, such as gaps formed in tungsten conductive layer having undesirably large widths with respect to the dimensions of the top opening of the contact hole using the conventional fabrication method, may be effectively improved. Compared to the tungsten conductive layer formed by the conventional fabrication method, the ratio of the width of a gap, formed in the tungsten conductive layer using the disclosed fabrication method, to the dimensions of the top opening of the contact hole, may be reduced by about 40% to about 50%.

Compared to conventional technology, the disclosed fabrication method and the conductive plug structure have several advantages.

The tungsten conductive layer may include at least two stacking tungsten conductive unit layers, and a tungsten conductive unit layer may include a tungsten nucleation layer and a tungsten bulk layer on the tungsten nucleation layer. That is, the tungsten nucleation layers and the tungsten bulk layer may be formed alternately to fill up a contact hole. The tungsten bulk layer in a tungsten conductive layer may be formed using the corresponding tungsten nucleation layer as the growth base to grow. Before the tungsten grain size of the tungsten bulk layer in a tungsten conductive unit layer increases to the fixed size, the deposition of the subsequent tungsten conductive unit layer may already start. The process may be repeated until the contact hole is filled up with the tungsten conductive layer.

In this way, the average tungsten grain size of each tungsten bulk layer may be desirably small so that the deposition/growth rate of each tungsten bulk layer may be desirably low. The difference between the growth/deposition rate of the tungsten bulk layer at the top opening of the contact hole and the growth rate of the tungsten bulk layer at the bottom of the contact hole may be reduced. It may take longer time to seal the contact hole with the tungsten conductive layer. The widths of the gaps formed in the contact hole may be reduced with respect to the top dimension of the contact hole.

Further, the thickness of each tungsten nucleation layer may range from about 20 Å to about 400 Å, and the thickness of each tungsten bulk layer may range from about 200 Å to about 1000 Å. If the thickness of a tungsten nucleation layer is less than about 20 Å, the tungsten nucleation layer may not be consistently distributed and the coverage of the tungsten nucleation layer may be reduced. If the thickness of a tungsten nucleation layer is greater than about 400 Å, the resistivity of the tungsten conductive layer may be too high. If the thickness of a tungsten bulk layer is less than about 200 Å, the resistivity of the tungsten conductivity layer may be too high. If the thickness of a tungsten bulk layer is greater than about 1000 Å, the tungsten grain size of the tungsten bulk layer may be undesirably large. The growth rate of the tungsten bulk layer may increase, which may cause the tungsten conductive layer to poorly fill up the contact hole. By forming the tungsten nucleation layers and the tungsten bulk layer in the disclosed ranges, the tungsten nucleation layers may have improved coverage, and the tungsten conductive layer may have desirably low resistivity. Also, because the tungsten grain size of tungsten in each tungsten bulk layer is desirably small, the tungsten bulk layers may grow desirably slow. The tungsten conductive layer may better fill up the contact hole.

It should be noted that, for illustrative purposes, the present invention only uses tungsten as an example for forming the tungsten conductive layer. In other various embodiments, other suitable materials, e.g., metals and/or alloys, may also be used to form the tungsten conductive layer using the structure and method disclosed. Details may be referred to the description of the present invention and are not repeated herein.

## Claims

1. A fabrication method for forming a conductive plug structure, comprising:
providing a semiconductor substrate;
forming a contact hole in the semiconductor substrate;
forming an insulating layer on the semiconductor substrate and a bottom and sidewalls of the contact hole; and
forming a metal conductive layer on the insulating layer to fill up the contact hole, the metal conductive layer including two or more stacking metal conductive unit layers, each metal conductive unit layer having a metal nucleation layer and a metal bulk layer on the metal nucleation layer.

2. The fabrication method according to claim 1, further comprising planarizing the metal conductive layer and the insulating layer to expose the semiconductor substrate.

3. The fabrication method according to claim 1 or 2, wherein a thickness of the metal nucleation layer ranges from about 20 Å to about 400 Å, and the thickness of a metal bulk layer ranges from about 200 Å to about 1000 Å.

4. The fabrication method according to any one of the claims 1-3, wherein a metal grain size of the metal nucleation layer ranges from about 0.01 µm to about 0.15 µm, and a metal grain size of the metal bulk layer ranges from about 0.1 µm to about 0.3 µm.

5. The fabrication method according to any one of the claims 1-4, wherein chemical vapor deposition (CVD) processes are performed to form the metal nucleation layer and the metal bulk layer of the metal conductive layer.

6. The fabrication method according to claim 5, wherein a reactant gas to form the metal nucleation layer includes SiH₄ and WF₆, a flow rate of the SiH₄ being about 10 sccm to about 200 sccm, a flow rate of the WF₆ being bout 10 sccm to about 100 sccm, a pressure of a reactor being about 4 Torr to about 60 Torr, a temperature of the CVD process being about 300 °C to about 450 °C, and/or,
wherein a reactant gas to form the metal bulk layer includes H₂ and WF₆, a flow rate of the H₂ being about 500 sccm to about 8000 sccm, a flow rate of the WF₆ being bout 30 sccm to about 150 sccm, a pressure of a reactor being about 30 Torr to about 300 Torr, a temperature of the CVD process being about 300 °C to about 450 °C.

7. The fabrication method according to any one of the claims 1-6, wherein before the metal conductive layer is formed, an adhesion layer is formed on the insulating layer for enhancing adhesion between the insulating layer and the metal conductive layer, and
wherein preferably the adhesive layer is formed by a physical vapor deposition (PCD) process, a thickness of the adhesive layer ranging from about 100 Å to about 500 Å.

8. The fabrication method according to any one of the claims 1-7, wherein before the metal conductive layer is formed, a barrier layer is formed on the insulating layer for preventing metal atoms of the metal conductive layer from diffusing into the semiconductor substrate.

9. The fabrication method according to claim 10, wherein the barrier layer is formed by one or more of an atom layer deposition (ALD) process and an or metal organic chemical vapor deposition (MOCVD) process, a thickness of the barrier layer ranging from about 50 Å to about 500 Å.

10. The fabrication method according to any one of the claims 1-9, wherein a chemical mechanical polishing is used to planarize the metal conductive layer and the insulating layer.

11. The fabrication method according to any one of the claims 1-10, wherein a top dimension of a contact hole is equal to or greater than about 0.065 µm.

12. A conductive plug structure, comprising:
a semiconductor substrate;
one or more contact holes in the semiconductor substrate;
an insulating layer covering a bottom and sidewalls of each contact hole; and
a metal conductive layer on the insulating layer filling up the contact hole, the metal conductive layer including two or more stacking metal conductive unit layers, each metal conductive unit layer having a metal nucleation layer and a metal bulk layer on the metal nucleation layer.

13. The method according to any one of the claims 1 to 11 or the conductive plug structure according to claim 12, wherein the metal conductive layer is made of tungsten.

14. The method according to any one of the claims 1 to 11 or the conductive plug structure according to claim 12, wherein the semiconductor substrate is made one or more of silicon, germanium, silicon germanium, and gallium arsenide.

15. The method according to any one of the claims 1 to 11 or the conductive plug structure according to claim 12, wherein the insulating layer is made of an oxide material.
